# EUROPÄISCHE PATENTSCHRIFT

(11) **EP 1 400 675 B1**
(45) Veröffentlichungstag und Bekanntmachung des Hinweises auf die Patenterteilung: **19.12.2007**
(21) Anmeldenummer: 03015717.6
(22) Anmeldetag: 10.07.2003
(51) Int. Cl.: F02D 41/20, F02M 51/06

(54) **Verfahren und Vorrichtung zur Steuerung wenigstens zweier Piezoaktoren**
Method and device for controlling at least two piezo-actuators
Procédé et dispositif pour contrôler au moins deux piézo-actionneurs

(30) Priorität: 23.09.2002 DE 10244092
(43) Veröffentlichungstag der Anmeldung: 24.03.2004
(73) Patentinhaber: ROBERT BOSCH GMBH, 70442 Stuttgart (DE)
(72) Erfinder: Rau, Andreas, 70469 Stuttgart (DE)

(56) Entgegenhaltungen:
- DE-A- 10 150 414
- DE-A- 10 158 547
- DE-A- 19 905 340
- US-A1- 2002 011 762
- US-A1- 2002 046 734

## Beschreibung

Die Erfindung betrifft ein Verfahren und eine Vorrichtung zur Steuerung wenigstens zweier Piezoaktoren.

Ein Verfahren und eine Vorrichtung zur Steuerung wenigstens zweier Piezoaktoren ist aus der EP 11 38 902 bekannt. Dort wird eine Endstufe zur Ansteuerung von mehreren Piezoaktoren beschrieben. Die an dem Piezoaktor anliegende Spannung wird dabei zu vorgegebenen Zeitpunkten erfasst und zur Bildung der Ansteuersignale verwendet.

Ferner ist aus der DE 199 05 340 A1 ein Verfahren und eine Anordnung zur Ansteuerung eines Piezoaktors beschrieben, bei der der Leerhub des Piezoaktors erfasst wird. Der erfasste Leerhub wird dann bei der Ansteuerung berücksichtigt.

Solche Piezoaktoren werden beispielsweise, wie es im Stand der Technik beschrieben ist, für Piezo-Common-Rail-Injektoren eingesetzt. Bei solchen Piezo-Common-Rail-Injektoren müssen sehr enge Toleranzen eingehalten werden, um eine genaue Kraftstoffzumessung zu erzielen. Von großer Bedeutung ist hierbei das Zusammenspiel von internem Piezoaktor und der Hydraulik. Üblicherweise stehen keine Informationen über das dynamische Verhalten der einzelnen Bauteile im Inneren des Injektors zur Verfügung, da entsprechende Sensoren nicht zur Verfügung stehen bzw. sehr hohe Kosten verursachen. Alterungserscheinungen, wie beispielsweise eine Alterung der Piezokeramik sowie Umgebungseinflüsse, wie Temperatureffekte, werden üblicherweise durch vorab definierte Kennfelder kompensiert. Mit einer solchen Kompensation ist nur eine sehr eingeschränkte Genauigkeit möglich.

Vorteile der Erfindung

Dadurch, dass ausgehend von der am Piezoaktor anliegenden Spannung eine Kenngröße für jeden Piezoaktor ermittelt wird, und dass die Kenngrößen der Piezoaktoren auf einen Sollwert eingeregelt werden, ist eine wesentlich genauere Steuerung des Piezoaktors möglich. Bei der Verwendung eines solchen Piezoaktors im Rahmen der Kraftstoffeinspritzung ist somit eine wesentlich genauere Kraftstoffzumessung möglich.

Vorzugsweise werden die Kenngrößen der wenigstens zwei Piezoaktoren auf einen gemeinsamen Sollwert eingeregelt. Eine besonders einfache Vorgabe des Mittelwerts ergibt sich, wenn als Sollwert der Mittelwert der Kenngrößen aller Piezoaktoren verwendet wird.

Die am Piezoaktor anliegende Spannung kann einfach erfasst werden, und/oder liegen bereits vor. Zusätzlichen Sensoren werden daher nicht benötigt.

Als Kenngrößen werden bevorzugt eine Flanke und/oder ein Extremwert und/oder ein Knick im Verlauf der elektrischen Größe verwendet, da diese in sehr enger Korrelation mit dem Beginn der Einspritzung und/oder dem Ende der Einspritzung stehen.

### Zeichnung

Die Erfindung wird nachstehend anhand der in der Zeichnung dargestellten Ausführungsform erläutert.

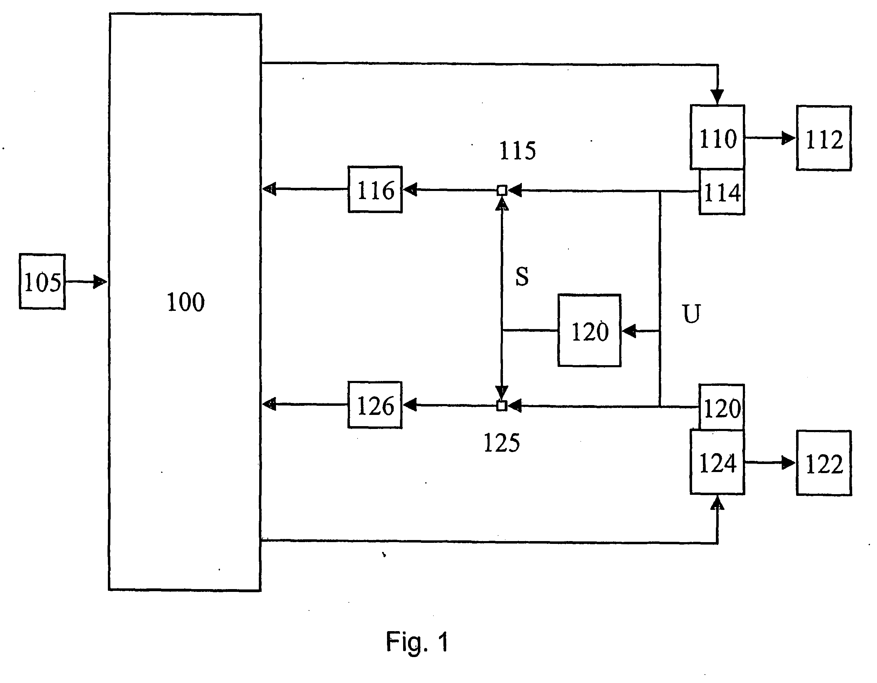

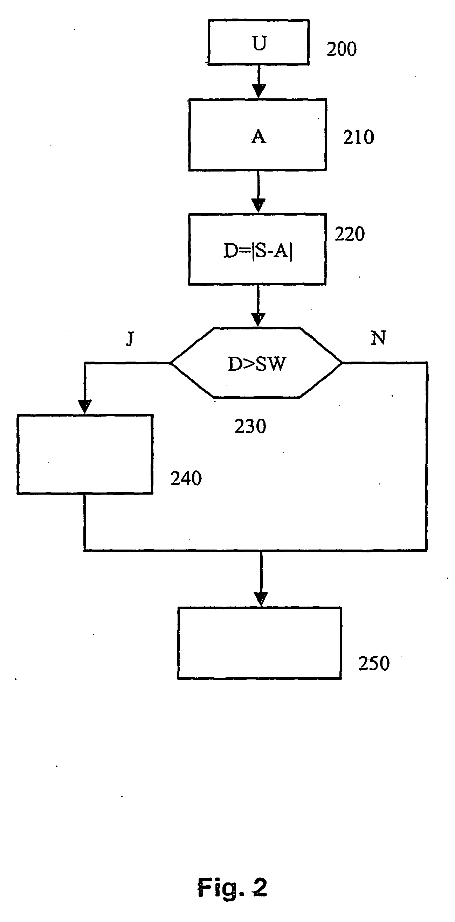

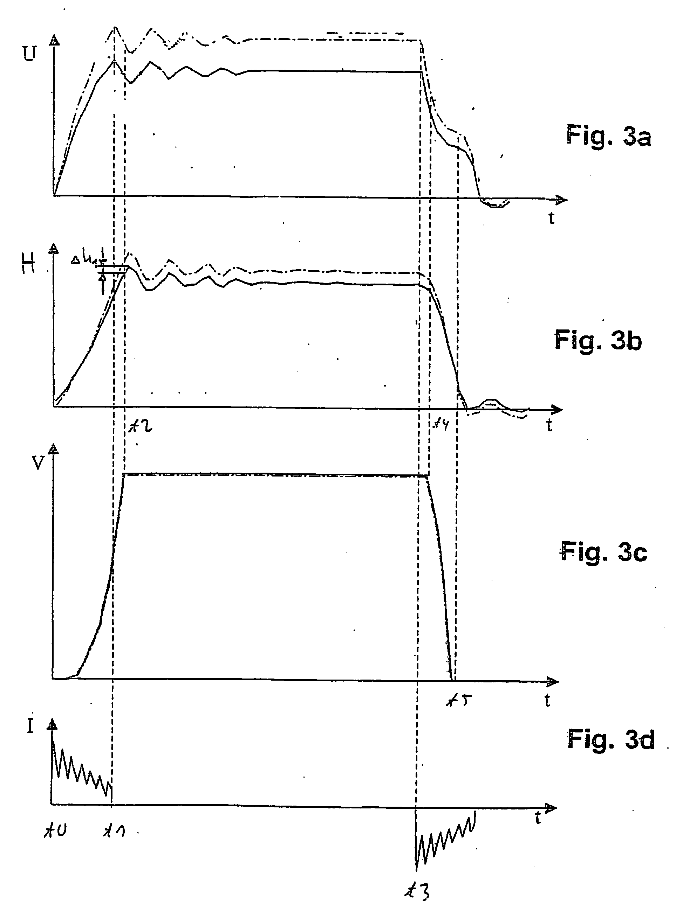

In Figur 1 ist die erfindungsgemäße Vorrichtung, in Figur 2 das erfindungsgemäße Verfahren und in Figur 3 verschiedene, über der Zeit aufgetragene Signale dargestellt.

### Beschreibung der Ausführungsbeispiele

Im Folgenden wird die erfindungsgemäße Vorgehensweise am Beispiel der Ansteuerung von zwei Piezoaktoren beschrieben. Die erfindungsgemäße Vorgehensweise ist dabei nicht auf die Anzahl von zwei Aktoren beschränkt, sie kann bei jeder beliebigen Anzahl von Aktoren eingesetzt werden. Die verwendeten Aktoren werden vorzugsweise zur Steuerung einer Brennkraftmaschine und dort zur Steuerung der eingespritzten Kraftstoffmenge verwendet.

Eine Steuereinheit ist mit 100 bezeichnet. Dieser werden die Signale verschiedener Sensoren 105 zugeführt. Diese Signale umfassen insbesondere die Drehzahl N der Brennkraftmaschine, ein Signal, das das Wunschmoment angibt und/oder ggf. weitere Betriebskenngrößen oder Größen, die die Umgebungsbedingungen charakterisieren.

Die Steuereinheit beaufschlagt eine erste Endstufe 110 mit Signalen, die Wiederum einen ersten Aktor 112 mit Ansteuersignalen beaufschlagt. Des weiteren ist eine erste Spannungserfassung 114 vorgesehen, die ein Signal U bereitstellt, das die am Aktor anliegende Spannung charakterisiert. Die Elemente 110, 114 und 112 und deren Funktionsweise sind im Wesentlichen aus dem Stand der Technik bekannt.

Das Signal U gelangt zu einer Sollwertbildung 120 sowie zu einem ersten Verknüpfungspunkt 115. Mit dem Ausgangssignal des Verknüpfungspunktes wird eine erste Regelung 116 beaufschlagt, die wiederum ein Ausgangssignal an die Steuereinheit 100 bereitstellt.

Entsprechend ist für einen zweiten Aktor 122 ebenfalls eine zweite Endstufe 124 sowie eine zweite Spannungsauswertung 120 vorgesehen. Die zweite Spannungsauswertung beaufschlagt wiederum die Sollwertbildung 120 und einen zweiten Verknüpfungspunkt 125 mit Signalen. Das Ausgangssignal des Verknüpfungspunktes 125 gelangt zu einer zweiten Regelung 126, die wiederum die Steuereinheit 100 beaufschlagt.

Ausgehend von den Eingangsgrößen, die die Steuereinheit 100 erfasst, berechnet sie Zeitpunkte, bei denen der Aktor anzusteuern und abzusteuem ist, d.h. die Zeitpunkte, bei denen die Aufladung und die Zeitpunkte, bei denen die Entladung des Aktors beginnt. Diese Ansteuersignale setzt die Endstufe in entsprechende Ansteuersignale zur Beaufschlagung von diversen Schaltmittel, die zur Entladung oder zur Ladung des Aktors dienen, um. Zur genauen Ansteuerung wird üblicher Weise die Spannung U, die am Aktor anliegt, erfasst und zur Bildung der Ansteuersignale des Aktors verwendet.

Erfindungsgemäß ist nun vorgesehen, diese Spannungswerte einer Regelung zuzuführen. Dabei wird für jeden Aktor wenigstens eine Kenngröße ermittelt. Diese Kenngröße für jeden Aktor wird dann mittels der jeweiligen Regelung 116 bzw. 126 auf einen Sollwert eingeregelt. Bevorzugt erfolgt die Regelung so, dass die Kenngrößen aller Aktoren auf einen gemeinsamen Sollwert geregelt werden, d.h. die Kenngrößen aller Aktoren werden gleichgestellt.

Bei einer einfachen Ausführungsform, wie sie in Figur 1 dargestellt wird, ist vorgesehen, dass die Kenngrößen aller Aktoren einer Sollwertbildung 120 zugeführt und dort ein gemeinsamer Mittelwert aller Kenngrößen gebildet wird, der dann als Sollwert den einzelnen Regelungen zugeführt wird. Bei einer alternativen Ausgestaltung kann es auch vorgesehen sein, dass ein gemeinsamer Sollwert von der Steuereinheit 100 vorgegeben wird.

Ausgehend von der Stellgröße der Regelungen 116 und 126 beeinflusst dann die Steuereinheit 100 die Endstufe derart, dass die Istwerte sich den Sollwerten annähern, bei einer alternativen Ausgestaltung kann die Regelung so ausgebildet sein, dass das Ausgangssignal der Regelung unmittelbar der jeweiligen Endstufe zugeführt wird und dass die Verarbeitung der Stellgröße in der Endstufe erfolgt.

Erfindungsgemäß ist vorgesehen, dass ausgehend von einem Signal, vorzugsweise handelt es sich hierbei um die Spannung, die am Piezoaktor abfällt, das für die Ansteuerung des Piezoaktors verwendet wird, ein Zeitpunkt erkannt wird, bei dem das Steuerventil öffnet bzw. wieder geschlossen ist. Dadurch ergibt sich die Möglichkeit, das Verhalten des Ventils, welches die Einspritzmenge bestimmt, zu überwachen und bei auftretenden Abweichungen auszuregeln. Dabei ist es möglich, im laufenden Betrieb des Aktors bzw. der Brennkraftmaschine Alterungseffekte auszuregeln. Solche Alterungseffekte führen beispielsweise dazu, dass der Hub und/oder die Kraft des Aktors im Laufe der Zeit bei gleichem Ansteuersignal sich verringert. Das hieraus resultierende geänderte Verhalten des Aktors und des Ventils würde zu einer Einspritzmengenänderung über die Lebenszeit des Injektors führen. Dieser Effekt kann durch die erfindungsgemäße Vorgehensweise in einfacher Weise ohne zusätzliche Sensoren kompensiert werden. Dadurch, dass eine Kenngröße eingeregelt wird, können die Toleranzen in der Schaltkette, bestehend aus Aktor, Koppler und/oder Schaltventil, deutlich aufgeweitet werden, was zu einer Kostenersparnis führt.

Dabei wird die Piezokeramik selbst als Sensor benutzt, wodurch keine zusätzlichen Kosten entstehen. Durch Auswerten des im laufenden Betrieb anfallenden Spannungssignals am Aktor auf bestimmte Kenngrößen kann unmittelbar ermittelt werden, wann das Schaltventil bestimmte bevorzugte Positionen einnimmt, d.h. es wird insbesondere ermittelt, wann das Schaltventil geöffnet und wieder geschlossen ist. Besonders vorteilhaft dabei ist, dass eine direkte Messgröße zur Verfügung steht, über die das Ventilverhalten überwacht und damit aufgeregelt werden kann. Somit können Effekte wie Alterung und Temperaturdrift ausgeregelt werden und müssen nicht über Kennlinien kompensiert werden.

Üblicherweise wird in der Ladephase der Aktor, der elektrisch als Kapazität wirkt, bestromt, was wiederum einen Spannungsanstieg zur Folge hat. Die Ausdehnung der Piezokeramik ist näherungsweise proportional zum anliegenden elektrischen Feld und damit auch zur Spannung. Durch die Ansteuerung dehnt sich der Aktor aus. Diese Ausdehnung wird auch als Hub H bezeichnet. Im üblichen Betrieb wird aus energetischen Gründen der Strom abgeschaltet, bevor das Schaltventil seine Endlage erreicht. Da das Ventil und damit der Aktor auf Grund der Eigengeschwindigkeit und der in einem Koppler gespeicherten Druckenergie sich noch weiter bewegt, nimmt auf Grund des piezoelektrischen Effekts die Spannung ab. Dies ist im Spannungs-Zeit-Diagramm als Knick zu erkennen. Die Spannung nimmt so lange ab, bis das Ventil eine neue Endlage erreicht. Der Aktor legt noch eine kleine Strecke zurück, bevor er zurück federt und ausschwingt. Diese kleine Strecke ist in Figur 3b mit Δh₁ bezeichnet. Das Zurückfedern bedeutet eine Bewegungsrichtungsumkehr, was sich in einem ausgeprägten Minimum in der Spannungskennlinie zeigt. Dieses Minimum steht, abgesehen von einer kleinen zeitlichen Verzögerung, in einem direkten Zusammenhang mit dem Erreichen der neuen Endlage.

Erfindungsgemäß ist nun vorgesehen, dass dieses erste Minimum als Kenngröße verwendet wird.

Entsprechend kann auch beim Schließen des Ventils vorgegangen werden. Während der Haltephase in seiner zweiten Position bleibt die Ladung auf dem Piezoaktor konstant. Zum Schließen wird der Aktor über einen entsprechenden Entladestrom entladen. Dies führt zu einem Absinken der Spannung. Der Aktor zieht sich dabei immer mehr zusammen. Bewegt sich das Ventil wieder in seine erste Endlage, so bewirkt dies in der Spannungslinie einen zeitlichen Versatz. Dieser Versatz kann als Kenngröße verwendet werden. Dadurch kann auch das Schließverhalten des Steuerventils auf vorgegebene Sollwerte eingeregelt werden.

Durch die erfindungsgemäße Vorgehensweise können Auswirkungen von Alterungserscheinungen, insbesondere der Piezokeramik, auf die Einspritzmenge und/oder den Einspritzbeginn minimiert werden.

In Figur 2 ist die erfindungsgemäße Vorgehensweise beispielhaft anhand eines Flussdiagrammes dargestellt. In einem ersten Schritt 200 wird eine elektrische Größe U für jeden Piezoaktor ermittelt. Vorzugsweise wird die Spannung, die am Piezo anliegt, ausgewertet. Diese Spannung wird üblicher Weise zur Ansteuerung des Piezoaktors verwendet und liegt dabei in der Regel in der Steuereinheit und/oder in den Endstufen vor. In einem zweiten Schritt 210 wird, ausgehend von der elektrischen Größe U, die Kenngröße A ermittelt. Als Kenngröße wird insbesondere die zeitliche Lage des ersten Minimums der Spannung U und/oder der Knick in der abfallenden Flanke ermittelt. D.h. es werden charakteristische Zeitpunkte des Signals ermittelt.

In einem anschließenden Schritt 220 wird die Abweichung D, insbesondere der Betrag der Abweichung, der einzelnen Kenngrößen von einem gemeinsamen Sollwert S bestimmt. Diese Größe D gibt an, inwieweit die einzelnen Kenngrößen der einzelnen Aktoren von dem gemeinsamen Sollwert abweichen. Bei der erfindungsgemäßen Ausgestaltung, die in Figur 1 dargestellt ist, wird als gemeinsamer Sollwert der Mittelwert über alle Kenngrößen verwendet. Alternativ können auch andere Sollwerte verwendet werden.

Die anschließende Abfrage 230 überprüft, ob diese Abweichung D größer als ein Schwellenwert SW ist. Ist dies nicht der Fall, d.h. die einzelnen Kenngrößen weichen nur unwesentlich voneinander oder von einem gemeinsamen Sollwert ab, so endet das Programm in Schritt 250. Ist dies nicht der Fall, so werden im Schritt 240 Korrekturwerte zur Korrektur der Ansteuerung ermittelt. Diese werden von der Steuereinheit 100 oder von der Endstufe verwendet, um die Ansteuerung entsprechend zu korrigieren.

In Figur 3 sind verschiedene Signale über der Zeit t aufgetragen. In Figur 3a ist die Spannung U, die an zwei Piezoaktoren anliegt, aufgetragen. In Figur 3b der Hub H der entsprechenden Injektoren, in Figur 3c der Hub des Schaltventils und in Figur 3d der Strom, der zum Laden bzw. Entladen des Piezoaktors dient, über der Zeit t aufgetragen. Zum Zeitpunkt t0 beginnt der Ladevorgang des Injektors. Dies hat zur Folge, dass die Spannung am Injektor ansteigt. Dieser Anstieg der Spannung wiederum bewirkt eine Ausdehnung, d.h. einen Hub H des Piezoaktors. Dieser wiederum bewirkt einen Anstieg des Hubes V das Schaltventil. Zum Zeitpunkt t1 endet die Bestromung des Piezoaktors. Zum Zeitpunkt t2 erreicht das Schaltventil seine Endposition. Ab dem Zeitpunkt t1 tritt eine Schwingung in dem Spannungssignal und in dem dem Hub in der Hubgröße H des Piezos auf, die durch eine Schwingung des Piezoaktors, die auf verschiedenen Ursachen beruht, zurückgeht.

Erfindungsgemäß wurde erkannt, dass das erste Minimum im wesentlichen mit dem Zeitpunkt t2 korreliert ist. D.h. bei allen Aktoren, bei denen das erste Minimum zum gleichen Zeitpunkt auftritt, tritt auch der Zeitpunkt t2, bei dem das Ventil seine neue Endlage erreicht, zum gleichen Zeitpunkt auf. Erfindungsgemäß wird diese Lage des ersten Minimums als Kenngröße verwendet. Diese Kenngröße dient insbesondere zur Einstellung des Beginns der Kraftstoffzumessung.

Zum Zeitpunkt t3 beginnt die Bestromung zur Entladung des Piezoaktors. Zum Zeitpunkt t4 beginnt das Schaltventil, sich in ihre ursprüngliche Endlage zurück zu bewegen. Zum Zeitpunkt t5 hat das Schaltventil seine Ausgangslage wieder erreicht. Zu diesem Zeitpunkt tritt auf Grund von hydraulischen Rückwirkungen der Spannung U ein charakteristischer Signalverlauf auf. Auch dieser wird erkannt und als Kenngröße verwendet. Mit dieser Kenngröße wird bevorzugt das Ende der Einspritzung und damit in Verbindung mit dem Beginn der Einspritzung bzw. der ersten Kenngröße die Dauer der Einspritzung bestimmt.

## Patentansprüche

1. Verfahren zur Regelung wenigstens zweier Piezoaktoren, bei dem eine Kenngröße für jeden Piezoaktor ermittelt wird, wobei die Kenngrößen der wenigstens zwei Piezoaktoren auf einen Sollwert eingeregelt werden, dass die Kenngröße ausgehend von der am Piezoaktor anliegenden Spannung bestimmt wird.

2. Verfahren nach Anspruch 1, **dadurch gekennzeichnet, dass** die Spannung zur Ansteuerung des Piezoaktors verwendet wird.

3. Verfahren nach wenigstens einem der vorhergehenden Ansprüche, **dadurch gekennzeichnet, dass** als Kenngröße eine Flanke und/oder ein Extremwert und/oder ein Knick im Verlauf der Spannung verwendet wird.

4. Verfahren nach wenigstens einem der vorhergehenden Ansprüche, **dadurch gekennzeichnet, dass** als Sollwert der Mittelwert der Kenngrößen verwendet wird.

5. Vorrichtung zur Regelung wenigstens zweier Piezoaktoren, bei der eine Kenngröße für jeden Piezoaktor ermittelt wird, wobei die Kenngrößen der wenigstens zwei Piezoaktoren auf einen Sollwert eingeregelt werden und dass die Kenngröße ausgehend von der am Piezoaktor anliegenden Spannung bestimmt wird.

## Claims

1. Method for controlling at least two piezoactuators, in which a characteristic variable is determined for each piezo-actuator, wherein the characteristic variables of the at least two piezoactuators are adjusted to a setpoint value, in that the characteristic variable is determined on the basis of the voltage which is applied to the piezo-actuator.

2. Method according to Claim 1, **characterized in that** the voltage is used to actuate the piezo-actuator.

3. Method according to at least one of the preceding claims, **characterized in that** a signal edge and/or an extreme value and/or a kink in the profile of the voltage is used as the characteristic variable.

4. Method according to at least one of the preceding claims, **characterized in that** the mean value of the characteristic variables is used as a setpoint value.

5. Device for controlling at least two piezoactuators, in which a characteristic variable is determined for each piezo-actuator, wherein the characteristic variables of the at least two piezoactuators are adjusted to a setpoint value, and in that the characteristic variable is determined on the basis of the voltage which is applied to the piezo-actuator.

## Revendications

1. Procédé de régulation d'au moins deux actionneurs piézoélectriques, selon lequel on détermine une grandeur caractéristique pour chaque actionneur piézoélectrique, les grandeurs caractéristiques d'au moins deux actionneurs piézoélectriques étant régulées sur une valeur de consigne,
**caractérisé en ce que**
la grandeur caractéristique est déterminée à partir de la tension raccordée à l'actionneur piézoélectrique.

2. Procédé selon la revendication 1,
**caractérisé en ce que**
la tension est utilisée pour la commande de l'actionneur piézoélectrique.

3. Procédé selon au moins l'une des revendications précédentes,
**caractérisé en ce que**
comme grandeur caractéristique on utilise un flanc et/ou une valeur extrême et/ou une inflexion dans l'évolution de la tension.

4. Procédé selon au moins l'une quelconque des revendications précédentes,
**caractérisé en ce que**
comme valeur de consigne on utilise la valeur moyenne des grandeurs caractéristiques.

5. Dispositif de régulation d'au moins deux actionneurs piézoélectriques, dans lequel une grandeur caractéristique est déterminée pour chaque actionneur piézoélectrique, les grandeurs caractéristiques d'au moins deux actionneurs piézoélectriques étant régulées sur une valeur de consigne, et la grandeur caractéristique est déterminée à partir de la tension raccordée à l'actionneur piézoélectrique.
